(19) **Europäisches Patentamt / European Patent Office / Office européen des brevets**

(11) **EP 4 726 418 A1**

(12) **EUROPEAN PATENT APPLICATION**
published in accordance with Art. 153(4) EPC

(43) Date of publication:
**15.04.2026 Bulletin 2026/16**

(21) Application number: **25739165.6**

(22) Date of filing: **10.01.2025**

(51) International Patent Classification (IPC):
**G01R 31/392** $^{(2019.01)}$        **G01R 31/396** $^{(2019.01)}$
**G01R 31/382** $^{(2019.01)}$

(52) Cooperative Patent Classification (CPC):
**G01R 31/396; G01R 31/382; G01R 31/3842;
G01R 31/392; H01M 10/425; H01M 10/48;
H01M 10/482;** H01M 2010/4271; H01M 2220/20;
Y02E 60/10

(86) International application number:
**PCT/KR2025/000677**

(87) International publication number:
**WO 2025/151005 (17.07.2025 Gazette 2025/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.01.2024 KR 20240005640**

(71) Applicant: **LG Energy Solution, Ltd.
Seoul 07335 (KR)**

(72) Inventors:
• **KIM, Ji-Yeon
  Daejeon 34122 (KR)**
• **KIM, Young-Deok
  Daejeon 34122 (KR)**
• **PARK, Jun-Cheol
  Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY MANAGEMENT DEVICE AND METHOD**

(57)    A battery managing apparatus according to an embodiment of the present disclosure includes a profile acquisition unit configured to acquire a first profile for each of a plurality of batteries included in a battery pack; and a diagnosis unit configured to calculate a target value based on a capacity value for each of the plurality of batteries as a diagnostic factor on a basis of a first target point included in each of the plurality of first profiles, generate a distribution profile indicating a correspondence relationship between a plurality of calculated target values and the number of each of the plurality of target values, determine whether the distribution profile satisfies a predetermined condition, and diagnose a state of the battery pack according to a determination result.

**FIG. 1**

EP 4 726 418 A1

**Description**

TECHNICAL FIELD

This application is based on and claims priority from Korean Patent Application No. 10-2024-0005640 filed on January 12, 2024, with the Korean Intellectual Property Office, the disclosure of which is incorporated herein in its entirety by reference.

The present disclosure relates to a battery managing apparatus and method, and more particularly, to a battery managing apparatus and method that are capable of diagnosing the state of a battery pack.

BACKGROUND

Recently, as the demand for portable electronic products such as notebook computers, video cameras, and portable telephones has rapidly increased, and as the development of electric vehicles, energy storage batteries, robots, and satellites has begun in earnest, research on the high-performance batteries allowing repeated charging and discharging are being actively conducted.

Currently, commercially available batteries include, for example, nickelcadmium batteries, nickel-hydrogen batteries, nickel-zinc batteries, and lithium batteries. Of these batteries, lithium batteries are gaining considerable attention due to their advantages including a substantially low memory effect to allow a high degree of freedom in charging and discharging, a very low self-discharging rate, and high energy density, as compared to nickel-based batteries.

Batteries are used in various fields, and in many cases, large-capacity batteries are required in the fields where batteries are being widely used recently, such as electrically-driven vehicles or smart grid systems. In order to increase the capacity of a battery pack, a method for increasing the capacity of a secondary battery, that is, a battery cell itself, may be used. However, in this case, there are disadvantages in that there exist physical limitations on the size expansion of the secondary battery and inconvenience of management thereof, while the effect of increasing the capacity is not significant. Therefore, battery packs including a plurality of battery cells connected in series and in parallel are widely used in general.

SUMMARY

The present disclosure provides a battery managing apparatus and method that are capable of diagnosing the state of a degradation imbalance among a plurality of batteries included in a battery pack.

Other objects and advantages of the present disclosure may be understood by the following description, and will be more clearly understood by embodiments of the present disclosure. In addition, it will be easily understood that the objects and advantages of the present disclosure may be implemented by the means and combinations thereof indicated in the patent claims.

A battery managing apparatus according to one aspect of the present disclosure may include a profile acquisition unit configured to acquire a first profile for each of a plurality of batteries included in a battery pack; and a diagnosis unit configured to calculate a target value based on a capacity value for each of the plurality of batteries as a diagnostic factor on the basis of a first target point included in each of the plurality of first profiles, generate a distribution profile indicating a correspondence relationship between a plurality of calculated target values and the number of each of the plurality of target values, determine whether the distribution profile satisfies a predetermined condition, and diagnose a state of the battery pack according to a determination result.

The first profile may be a negative electrode profile, and the first target point may be a negative electrode activation initial point indicating a negative electrode point at which a charging reaction starts, or a discharging reaction ends in the negative electrode profile.

When the distribution profile does not satisfy the predetermined condition, the diagnosis unit may be configured to diagnose the state of the battery pack as a degradation imbalance state.

When the distribution profile satisfies the predetermined condition, the diagnosis unit may be configured to compare a feature value of the distribution profile with a preset threshold value, and diagnose the state of the battery pack based on a comparison result.

When the feature value exceeds the threshold value, the diagnosis unit may be configured to diagnose the state of the battery pack as a degradation imbalance state.

When the feature value is less than or equal to the threshold value, the diagnosis unit may be configured to diagnose the state of the battery pack as a degradation balance state.

The diagnosis unit may be configured to set the threshold value based on a degradation degree of the battery pack and a preset reference feature value.

The diagnosis unit may be configured to calculate a first value and a second value based on the plurality of target values, and determine whether the distribution profile satisfies the predetermined condition based on a ratio between the first value and the second value.

The diagnosis unit may be configured to determine a minimum value, a maximum value, and a reference value among the plurality of target values, calculate a difference between the minimum value and the reference value as the first value, and calculate a difference between the reference value and the maximum value as the second value.

The diagnosis unit may be configured to determine a target value having a maximum correspondence number among the plurality of target values as the reference value.

When the ratio falls within a preset critical ratio range, the diagnosis unit may be configured to determine that the distribution profile satisfies the predetermined condition.

When the ratio does not fall within the critical ratio range, the diagnosis unit may be configured to determine that the distribution profile satisfies the predetermined condition.

The diagnosis unit may be configured to calculate a state of charge (SOC) of the first target point based on a ratio of a capacity value of the first target point to a reference capacity set for each of the plurality of batteries, and determine the calculated SOC as the target value.

The diagnosis unit may be configured to determine the target value based on the reference capacity set for each of the plurality of batteries, the first target point, and a second target point included in each of the plurality of first profiles. The first profile may be a negative electrode profile, and the second target point may be a negative electrode activation final point included in the negative electrode profile.

The diagnosis unit may be configured to operate a function for resolving a degradation imbalance or outputs an alarm when the state of the battery pack is diagnosed to be a degradation imbalance state.

The function for resolving the degradation imbalance may be a pack balancing function.

A battery pack according to another aspect of the present disclosure may include the battery managing apparatus according to one aspect of the present disclosure.

A vehicle according to still another aspect of the present disclosure may include the battery managing apparatus according to one aspect of the present disclosure.

A battery managing method according to still another aspect of the present disclosure may include a profile acquisition step of acquiring a first profile for each of a plurality of batteries included in a battery pack; a target value calculation step of calculating a target value based on a capacity value for each of the plurality of batteries as a diagnostic factor on the basis of a first target point included in each of the plurality of first profiles; a profile generation step of generating a distribution profile indicating a correspondence relationship between a plurality of calculated target values and the number of each of the plurality of target values; a condition determination step of determining whether the distribution profile satisfies a predetermined condition; and a state diagnosis step of diagnosing a state of the battery pack according to a determination result.

The battery managing method may further include a countermeasure step of operating a function for resolving the degradation imbalance or outputting an alarm when the state of the battery pack is diagnosed as a degradation imbalance state in the state diagnosis step.

A storage medium according to still another aspect of the present disclosure is a non-transitory readable storage medium having stored therein a program for executing a battery managing method including: a profile acquisition step of acquiring a first profile for each of a plurality of batteries included in the battery pack; a target value calculation step of calculating a target value based on a capacity value for each of the plurality of batteries as a diagnosis factor on the basis of a first target point included in each of the plurality of first profiles; a profile generation step of generating a distribution profile indicating a correspondence relationship between a plurality of calculated target values and the number of each of the plurality of target values; a condition determination step of determining whether the distribution profile satisfies a predetermined condition; and a state diagnosis step of diagnosing a state of the battery pack according to a determination result.

According to one aspect of the present disclosure, a battery managing apparatus according to the present disclosure may diagnose the state of a degradation imbalance among a plurality of batteries included in a battery pack.

The effects of the present disclosure are not limited to the effects mentioned above, and other effects not mentioned will be clearly understood by those skilled in the art from the description of the claims.

BRIEF DESCRIPTION OF THE DRAWINGS

The following drawings attached to the specification serve to further understand the technical idea of the present disclosure together with the detailed description of the present disclosure described below, so that the present disclosure should not be interpreted as being limited to matters described in such drawings.

FIG. 1 is a diagram schematically illustrating a battery managing apparatus according to an embodiment of the present disclosure.

FIG. 2 is a diagram schematically illustrating a positive electrode profile and a positive electrode activation initial point according to an embodiment of the present disclosure.

FIG. 3 is a diagram schematically illustrating a first distribution profile according to an embodiment of the present disclosure.

FIG. 4 is a diagram schematically illustrating a second distribution profile according to an embodiment of the present disclosure.

FIG. 5 is a diagram schematically illustrating a reference positive electrode profile and a reference negative electrode profile according to an embodiment of the present disclosure.

FIGS. 6 to 8 are reference diagrams for explaining an example of a procedure for generating a comparison profile used for comparison with a battery profile according to an embodiment of the present disclosure.

FIGS. 9 to 11 are reference diagrams for explaining another example of a procedure for generating a comparison profile used for comparison with a battery profile according to an embodiment of the present disclosure.

FIG. 12 is a diagram illustrating an example configuration of a battery pack according to another embodiment of the present disclosure.

FIG. 13 is a view schematically illustrating a vehicle according to still another embodiment of the present disclosure.

FIG. 14 is a diagram schematically illustrating a battery managing method according to still another embodiment of the present disclosure.

FIG. 15 is a diagram schematically illustrating a condition determination step and a state diagnosis step of the battery managing method according to still another embodiment of the present disclosure.

## DETAILED DESCRIPTION

The terms and words used in the specification and claims should not be construed as being limited to their ordinary or dictionary meanings, but should be construed as meanings and concepts consistent with the technical idea of the present disclosure based on a principle that an inventor may appropriately define the concepts of terms in order to explain his or her invention in the best possible manner.

Therefore, embodiments in the specification and configurations illustrated in the drawings are merely provided as examples and do not represent all of the technical ideas of the present disclosure, so it should be understood that there may be various equivalents and modifications that could replace the technical ideas at the time of filing this application.

Also, in the description of the present disclosure, when it is deemed that explanation of related well-known constructions or functions may obscure the essence of the present disclosure, the detailed description thereof is omitted.

The terms including the ordinal number such as "first", "second", and the like, may be used to distinguish one element from another element among various elements, but these terms are not intended to limit the elements.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element interposed therebetween.

Generally, batteries are degraded as they are used, but the degradation state of each of a plurality of batteries included in a battery pack may be different from each other due to the reason such as repeated charging and discharging of the battery pack or the battery pack being left for a long period of time. For example, the degradation state of each of the plurality of batteries included in the battery pack may not be uniform.

As the batteries are degraded, the available capacity decreases. Thus, when the degradation state of the plurality of batteries in the battery pack is not uniform, the available capacity of each of the batteries may be different from each other. In this case, the available capacity of the battery pack may be determined based on a minimum available capacity among the available capacities of the plurality of batteries.

For example, it is assumed that a battery pack includes five batteries connected in series, the available capacity of four batteries thereof is 100 [Ah], and the available capacity of one battery thereof is 90 [Ah]. In this case, the available capacity of the battery pack is 450 [Ah], not 490 [Ah]. At this time, since the degradation of the plurality of batteries is not uniform, there is a problem that the capacity of 40 [Ah] is not usable.

The present disclosure provides a technology capable of diagnosing the state of a degradation imbalance among a plurality of batteries included in a battery pack.

Hereinafter, embodiments of the present disclosure will be described in detail with reference to the attached drawings.

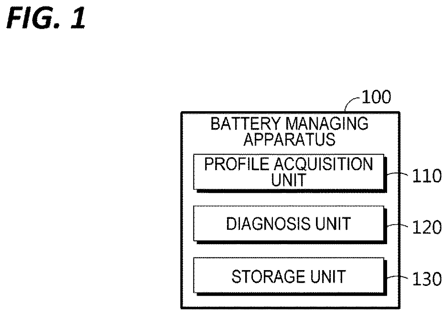

FIG. 1 is a diagram schematically illustrating a battery managing apparatus 100 according to an embodiment of the present disclosure.

Referring to FIG. 1, the battery managing apparatus 100 may include a profile acquisition unit 110 and a diagnosis unit 120.

The profile acquisition unit 110 may be configured to acquire a first profile for each of the plurality of batteries included in the battery pack.

Here, the battery refers to a single, physically separable independent cell including a negative terminal and a positive terminal. For example, the battery may be a lithium-ion battery or a lithium polymer battery. The type of the battery may be a cylindrical type, a prismatic type, or a pouch type. In addition, the battery may mean a battery bank or a battery module in which a plurality of cells are connected in series and/or in parallel. Hereinafter, for the convenience of explanation, the battery is described as meaning a single independent cell.

Here, the first profile may be a negative electrode profile, and a first target point included in the first profile may be a negative electrode activation initial point included in the negative electrode profile.

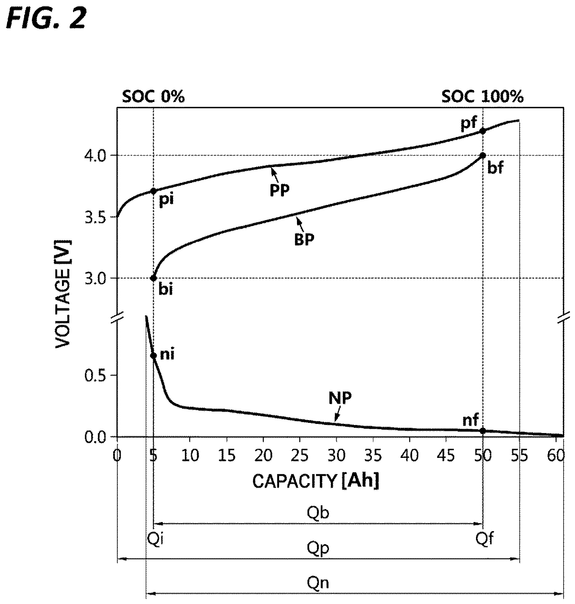

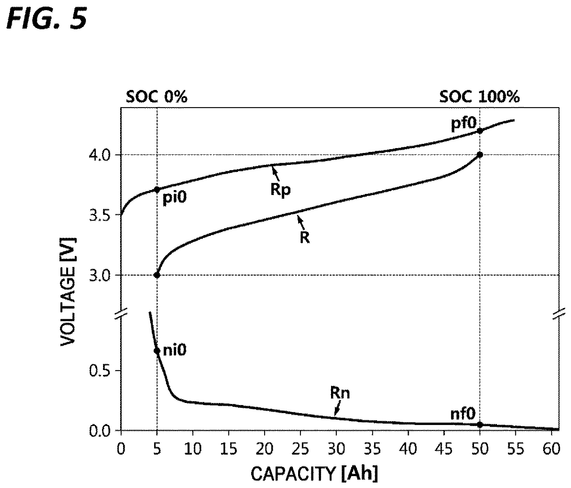

FIG. 2 is a diagram schematically illustrating a negative electrode profile NP and a negative electrode activation initial point ni according to an embodiment of the present disclosure. FIG. 5 is a diagram schematically illustrating a reference positive electrode profile Rp and a reference negative electrode profile Rn according to an embodiment of the present disclosure.

In the embodiments of FIGS. 2 and 5, the horizontal axis (X-axis) represents a capacity (Ah), and the vertical axis (Y-axis) represents a voltage (V).

For example, the profile acquisition unit 110 may acquire a battery profile BP indicating a correspondence relationship between the voltage and the capacity of a battery, and adjust a reference positive electrode profile Rp and a reference negative electrode profile Rn, which are preset to correspond to the battery profile BP, thereby acquiring the negative electrode profile NP and the negative electrode activation initial point ni.

Here, the battery profile BP may be a profile indicating a correspondence relationship between the voltage (V) and capacity (Q) when the battery is charged. Alternatively, the battery profile BP may be a profile indicating a correspondence relationship between the voltage (V) and the capacity (Q) when the battery is discharged.

The reference positive electrode profile Rp may be a profile indicating a correspondence relationship between the capacity and the voltage of a reference positive electrode cell preset to correspond to the positive electrode of the battery. For example, the reference positive electrode cell may be a positive electrode coin half-cell or a positive electrode of a three-electrode cell. In addition, the reference negative electrode profile Rn may be a profile indicating a correspondence relationship between the capacity and the voltage of a reference negative electrode cell preset to correspond to the negative electrode of the battery. For example, the reference negative electrode cell may be a negative electrode coin half-cell or a negative electrode of a three-electrode cell.

The profile acquisition unit 110 may acquire an adjusted positive electrode profile and an adjusted negative electrode profile by adjusting each of the reference positive electrode profile Rp and the reference negative electrode profile Rn (shifting the profile or performing capacity scaling thereto). The profile acquisition unit 110 may generate a comparison profile by synthesizing the adjusted positive electrode profile and the adjusted negative electrode profile (summing up capacity values for the same voltage value or summing up voltage values for the same capacity value). The profile acquisition unit 110 may generate a plurality of comparison profiles by repeating an adjustment procedure and a synthesis procedure for the reference positive electrode profile Rp and the reference negative electrode profile Rn. The profile acquisition unit 110 may specify a comparison profile with a minimum tolerance from the battery profile BP among the plurality of comparison profiles. The profile acquisition unit 110 may determine the adjusted positive electrode profile and the adjusted negative electrode profile used to generate the specified comparison profile as the positive electrode profile PP and the negative electrode profile NP of the battery.

In this regard, embodiments in which the profile acquisition unit 110 determines the negative electrode profile NP will be described later with reference to FIGS. 5 to 11.

As another example, the profile acquisition unit 110 may directly receive the negative electrode profile NP and the negative electrode activation initial point ni from the outside, instead of generating the first profile on its own. For example, the profile acquisition unit 110 may be connected to the outside in a wired and/or wireless manner to receive the negative electrode profile NP and the negative electrode activation initial point ni.

The diagnosis unit 120 may be configured to calculate a target value based on each of a plurality of first profiles and first target points.

For example, the diagnosis unit 120 may determine a target value based on a reference capacity set for each of the plurality of batteries and a capacity value of the first target point.

For example, the reference capacity may be set based on the positive electrode profile PP. For example, the reference capacity may be set as a positive electrode capacity Qp, which is a difference between a maximum capacity and a minimum capacity of the positive electrode profile PP. As another example, the reference capacity may be set as a negative electrode capacity Qn, which is a difference between a maximum capacity and a minimum capacity of the negative electrode profile NP. As another example, the reference capacity may be set as a battery capacity Qb, which is a difference between a maximum capacity and a minimum capacity of the battery profile BP. As long as the reference capacity refers to a value indicating the state of the battery, the reference capacity is not limited to the positive electrode capacity Qp, the negative electrode capacity Qn, and the battery capacity Qb, and various values may be applied thereto.

The diagnosis unit 120 may calculate the state of charge (SOC) at the first target point based on the ratio of the capacity value of the first target point to the reference capacity, and determine the calculated SOC as the target value. For example, the diagnosis unit 120 may divide the capacity value of the first target point by the reference capacity to calculate the SOC of the first target point, and determine the calculated SOC as the target value. Here, the capacity value of the first target point refers to a capacity value corresponding to the first target point on the first profile. For example, in the embodiment of FIG. 2, the capacity value of the first target point may be a difference between a starting capacity (0 [Ah] in FIG. 2) of the first profile NP and the capacity (5 [Ah] in FIG. 2) of the first target point (ni in FIG. 2).

Descriptions have been made above for an embodiment in which the SOC of the first target point is calculated as the target value. However, as long as the target value is a value capable of specifying the first target point, the target value is not limited to the SOC of the first target point, and may be applied in various manners. For example, the capacity value or voltage value of the first target point may also be applied as the target value.

The diagnosis unit 120 may be configured to generate a distribution profile indicating a correspondence relationship between a plurality of calculated target values and the number of each of the plurality of target values.

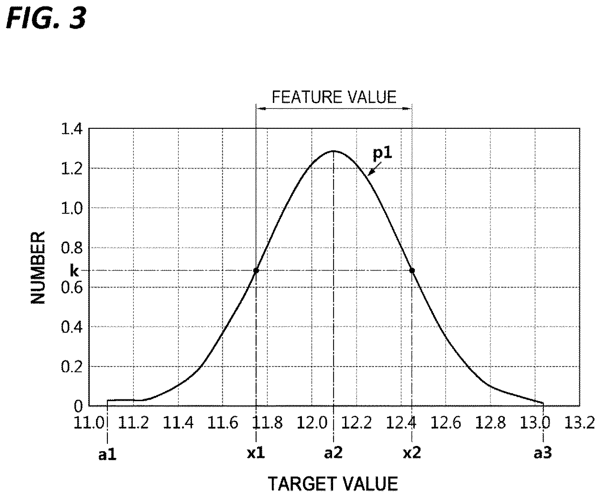

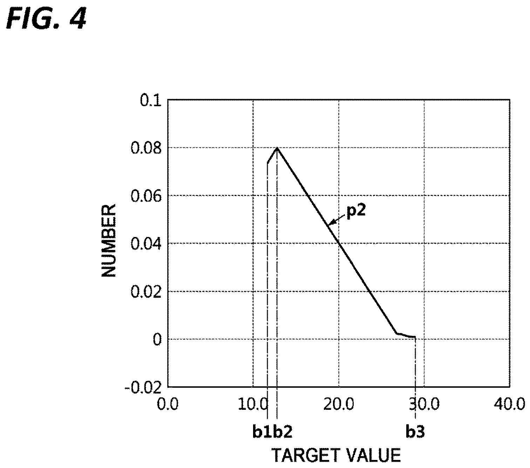

FIG. 3 is a diagram schematically illustrating a first distribution profile p1 according to an embodiment of the present disclosure. FIG. 4 is a diagram schematically illustrating a second distribution profile p2 according to an embodiment of the present disclosure.

In the embodiments of FIGS. 3 and 4, the horizontal axis (X-axis) represents target values, and the vertical axis (Y-axis) represents the number of each of a plurality of the target values.

As described above, the target value may be used as an indicator indicating the degradation degree of the battery. Thus, the distribution profile indicating the distribution of the plurality of target values may be used as a profile indicating the degree of degradation uniformity of the plurality of batteries.

The diagnosis unit 120 may be configured to determine whether the distribution profile satisfies a predetermined condition, and diagnose the state of the battery pack according to a determination result.

According to an embodiment, the predetermined condition may be a condition for determining whether the distribution profile follows a Gaussian distribution. That is, the predetermined condition may be a condition for determining whether the distribution profile exhibits the shape similar to the Gaussian distribution.

An embodiment in which the diagnosis unit 120 determines whether the distribution profile satisfies a predetermined condition will be described later with reference to FIGS. 3 and 4.

When the distribution profile does not satisfy the predetermined condition, the diagnosis unit 120 may be configured to diagnose the state of the battery pack as a degradation imbalance state.

The degradation imbalance state indicates a state in which the degradation state of each of the plurality of batteries included in the battery pack is not uniform. For example, when the degradation state of each of the plurality of batteries in the battery pack is not uniform, the maximum capacity capable of being used for each battery may be different.

Meanwhile, the degradation balance state indicates a state in which the degradation state of each of the plurality of batteries included in the battery pack is uniform. For example, even when the degradation state of each of the plurality of batteries is partially different, in the case that the degree of difference is minimal and may be ignored, the state of the battery pack may be diagnosed as the degradation balance state.

As batteries are degraded, the available capacity thereof decreases. Thus, when the degradation state of a plurality of batteries in a battery pack is not uniform, the available capacity of each of the batteries may be different from each other. For example, when the degradation state of the plurality of batteries in the battery pack is not uniform, all of the available capacities of the plurality of batteries may not be the same. In this case, the available capacity of the battery pack may be determined based on a minimum available capacity among available capacities of the plurality of batteries.

For example, it is assumed that a battery pack includes five batteries connected in series, and the available capacity of four batteries thereof is 100 [Ah], and the available capacity of one battery thereof is 90 [Ah]. In this case, the available capacity of the battery pack is 450 [Ah], not 490 [Ah]. That is, since the degradation of the plurality of batteries is not uniform, there is a problem that the capacity of 40 [Ah] is not usable.

The second distribution profile p2 illustrated in FIG. 4 is an example of a distribution profile that does not satisfy the predetermined condition. The diagnosis unit 120 may diagnose the state of the battery pack corresponding to the second distribution profile p2 as the degradation imbalance state.

When the distribution profile satisfies the predetermined condition, the diagnosis unit 120 may be configured to compare a feature value of the distribution profile with a preset threshold value, and diagnose the state of the battery pack based on a comparison result.

The first distribution profile p1 illustrated in FIG. 3 is an example of a distribution profile that satisfies the predetermined condition.

In the embodiment of FIG. 3, the diagnosis unit 120 may compare the feature value of the first distribution profile p1 with a preset threshold value, and diagnose the state of the battery pack based on the comparison result.

Here, the feature value indicates a difference between two target values having an identical correspondence number in the distribution profile. The number (Y-axis value) used to determine the feature value may be preset. For example, the feature value may refer to a full width at half maximum (FWHM). In this case, the number used to determine the feature value may be preset to half the maximum number in the distribution profile. As another example, the feature value may indicate a maximum difference between two target values having an identical correspondence number in the distribution profile. Referring to FIG. 3, the feature value of the first distribution profile p1 may be a difference (x2-x1) between two target values x1 and x2 having an identical correspondence number as k.

The threshold value may be preset based on the beginning of life (BOL) state of the battery pack, the current state of the battery pack (*e.g.,* the degradation degree), a reference value derived from a reference pack corresponding to the battery pack, or a theoretically derived distribution profile. The BOL stands for an initial state of the battery, which refers to a state in which the battery may exhibit a maximum capacity and performance at the time of the first use after the manufacture thereof.

According to an embodiment, when the feature value exceeds the threshold value, the diagnosis unit 120 may be configured to diagnose the state of the battery pack as the degradation imbalance state. In contrast, when the feature value is less than or equal to the threshold value, the diagnosis unit 120 may be configured to diagnose the state of the battery pack as the degradation balance state.

The battery managing apparatus 100 according to the present disclosure has an advantage of being able to diagnose whether the battery pack is in the degradation imbalance state, through the distribution of target values representing the degradation states of the plurality of batteries included in the battery pack.

Meanwhile, the profile acquisition unit 110 and the diagnosis unit 120 included in the battery managing apparatus 100 may selectively include a processor, an application-specific integrated circuit (ASIC), a chipset, a logic circuit, a register, a communication modem, and a data processing device, which are known in the art to execute various control logics performed in the present disclosure. In addition, when the control logic is implemented as software, the profile acquisition unit 110 and the diagnosis unit 120 may be implemented as a set of program modules. At this time, the program modules may be stored in a memory and executed by the profile acquisition unit 110 and the diagnosis unit 120. The memory may be located inside or outside the battery managing apparatus 100, and may be connected to the profile acquisition unit 110 and the diagnosis unit 120 by various means well-known in the art.

In addition, the battery managing apparatus 100 may further include a storage unit 130. The storage unit 130 may store data or programs necessary for each component of the battery managing apparatus 100 to perform operations and functions, or data generated in the process of performing the operations and functions. The type of the storage unit 130 is not particularly limited as long as it is an information storage means, which has been known to be able to record, erase, update, and read data. For example, the information storage means may include a random-access memory (RAM), a flash memory, a read-only memory (ROM), an electrically erasable programmable read-only memory (EEPROM), and a register. In addition, the storage unit 130 may store program codes in which processes executable by the profile acquisition unit 110 and the diagnosis unit 120 are defined.

The storage unit 130 may store information necessary for the profile acquisition unit 110 to acquire the battery profile. The storage unit 130 may store information necessary for the diagnosis unit 120 to diagnose the state of the battery pack. For example, the storage unit 130 may store a reference positive electrode profile, a reference negative electrode profile, and a reference capacity therein. The profile acquisition unit 110 and the diagnosis unit 120 may access the storage unit 130 to acquire the necessary information. For example, the first profiles and first target points for the plurality of batteries acquired by the profile acquisition unit 110 may be stored in the storage unit 130, and the diagnosis unit 120 may access the storage unit 130 to acquire the stored plurality of first profiles and plurality of first target points.

According to an embodiment, the diagnosis unit 120 may set a threshold value based on the degradation degree of the battery pack and a preset reference feature value. For example, a value capable of being calculated by associating the degradation degree of the battery pack with the preset reference feature value by the diagnosis unit 120 may be applied as a threshold value without limitation.

According to an embodiment, the diagnosis unit 120 may set a threshold value by multiplying the degradation degree of the battery pack and the preset reference feature value.

The degradation degree of the battery pack refers to the degradation degree of the battery pack. In other words, the degradation degree of the battery pack refers to a degradation rate of the battery pack. That is, the degradation degree of the battery pack is a concept opposite to the state of health (SOH) indicating a health condition of the battery pack, and may be represented by the formula of (100 - SOH) [%]. Here, the SOH is estimated based on the ratio of a current value (*e.g.*, capacity or resistance) to an initial value of the battery pack, and a conventional SOH estimation method may be applied thereto.

The reference feature value may be preset by considering the BOL state of the battery pack, the feature value of the distribution profile, or the specifications of the battery pack.

For example, the reference feature value may be preset to a specific value by considering the specifications of the battery pack. For example, a general value considering the specifications of the battery pack to be diagnosed may be preset as the reference feature value. Meanwhile, a general value considering the specifications of the battery pack may be preset to correspond to the feature value of the battery pack.

As another example, the reference feature value may be preset as a feature value of the reference distribution profile. Here, the reference distribution profile may mean a distribution profile acquired from the reference pack corresponding to the battery pack. Alternatively, the reference distribution profile may mean a distribution profile generated when the battery pack is in the BOL state. The feature value of the reference distribution profile refers to a difference between two target values having an identical correspondence number in the reference distribution profile. For example, the criterion for determining the feature value of the reference distribution profile may be identical to the criterion for determining the feature value of the distribution profile. Therefore, the feature value of the reference distribution profile and the feature value of the distribution profile determined based on the same criterion may be values corresponding to each other.

The threshold value may be set by considering the current degradation degree of the battery pack. Therefore, the battery managing apparatus 100 has an advantage of being able to diagnose the state of the battery pack more accurately based on the criterion (threshold value) for the current state of the battery pack.

Hereinafter, an embodiment in which the diagnosis unit 120 determines whether the distribution profile satisfies a predetermined condition will be described.

The diagnosis unit 120 may be configured to calculate a first value and a second value based on a plurality of target values, and determine whether the distribution profile satisfies a predetermined condition based on the ratio between the first value and the second value.

For example, the diagnosis unit 120 may calculate the first value and the second value based on a minimum value, a maximum value, and a reference value of the plurality of target values. For example, the diagnosis unit 120 may determine the minimum value, the maximum value, and the reference value among the plurality of target values. The diagnosis unit 120 may determine a target value with a maximum correspondence number among the plurality of target values as the reference value. In addition, the diagnosis unit 120 may be configured to calculate a difference between the minimum value and the reference value as the first value, and calculate the difference between the reference value and the maximum value as the second value. Finally, the diagnosis unit 120 may determine whether the distribution profile satisfies the predetermined condition based on the ratio between the first value and the second value.

In the embodiment of FIG. 3, the diagnosis unit 120 may determine a1 as a minimum value and a3 as a maximum value among a plurality of target values. In addition, the diagnosis unit 120 may determine a2, which has a maximum correspondence number among the plurality of target values, as a reference value. In addition, the diagnosis unit 120 may calculate the difference (a2-a1) between a1 and a2 as a first value, and calculate the difference (a3-a2) between a2 and a3 as a second value. The diagnosis unit 120 may calculate the ratio between the first value (a2-a1) and the second value (a3-a2), "(a2-a1) ÷ (a3-a2)" or "(a3-a2) ÷ (a2-a1)", and determine whether the distribution profile satisfies a predetermined condition based on a calculation result.

For example, when a1 is 11.1%, a2 is 12.1%, and a3 is 13.1%, the first value is 1% (12.1 - 11.1) and the second value is 1% (13.1 - 12.1). The ratio between the first value and the second value is 1.

In the embodiment of FIG. 4, the diagnosis unit 120 may determine b1 as a minimum value and b3 as a maximum value among a plurality of target values. In addition, the diagnosis unit 120 may determine b2, which has a maximum correspondence number among the plurality of target values, as a reference value. In addition, the diagnosis unit 120 may calculate the difference (b2-b1) between b1 and b2 as a first value, and calculate the difference (b3-b2) between b2 and b3 as a second value. The diagnosis unit 120 may calculate the ratio between the first value (b2-b1) and the second value (b3-b2), "(b2-b1) ÷ (b3-b2)" or "(b3-b2) ÷ (b2-b1)", and may determine whether the distribution profile satisfies a predetermined condition based on a calculation result.

For example, when b1 is 10.1%, b2 is 11.9%, and b3 is 29.2%, the first value is 1.8% (11.9 - 10.1) and the second value is 17.3% (29.2 - 11.9). The ratio between the first value and the second value is 9.61 (17.3 ÷ 1.8) or 0.10 (1.8 ÷ 17.3).

The diagnosis unit 120 may be configured to compare the ratio with a preset critical ratio range and determine whether the distribution profile satisfies the predetermined condition based on comparison result.

When the calculated ratio falls within the critical ratio range, the diagnosis unit 120 may determine that the distribution profile satisfies the predetermined condition. Alternatively, when the calculated ratio does not fall within the critical ratio range, the diagnosis unit 120 may be configured to determine that the distribution profile satisfies the predetermined condition.

When the ratio between the first value and the second value is equal to or greater than a lower limit value of the critical ratio range and is less than or equal to an upper limit value of the critical ratio range, the diagnosis unit 120 may determine that the calculated ratio falls within the critical ratio range. Then, the diagnosis unit 120 may determine that the distribution profile satisfies the predetermined condition. In contrast, when the ratio between the first value and the second value is less than the lower limit value or exceeds the upper limit value, the diagnosis unit 120 may determine that the ratio does not fall within the critical ratio range. Then, the diagnosis unit 120 may determine that the distribution profile does not satisfy the predetermined condition.

For example, the lower limit value of the critical ratio range may be set to 3 ÷ 7, and the upper limit value of the critical ratio range may be set to 7 ÷ 3. That is, the critical ratio range may be a range preset to check whether the ratio of the first value and the second value is included in 3:7 to 7:3. Hereinafter, the lower limit value of the critical ratio range is described as $3 \div 7$, and the upper limit value of the critical ratio range is described as $7 \div 3$, but it should be noted that such numerical values are not limited by the embodiment of the present disclosure.

As in the previous embodiment, it is assumed that the lower limit value of the critical ratio range is set to $3 \div 7$, and the upper limit value of the critical ratio range is preset to $7 \div 3$. In this case, in the embodiment of FIG. 3, since the ratio between the first value and the second value (first value (1%) $\div$ second value (1%) = 1) is equal to or greater than $3 \div 7$ and less than or equal to $7 \div 3$, the diagnosis unit 120 may determine that the ratio falls within the critical ratio range. In addition, the diagnosis unit 120 may determine that the first distribution profile p1 satisfies the predetermined condition.

As in the previous embodiment, it is assumed that the lower limit value of the critical ratio range is set to $3 \div 7$ and the upper limit value of the critical ratio range is preset to $7 \div 3$. In this case, in the embodiment of FIG. 4, when the critical ratio range is preset to be equal to or greater than $3 \div 7$ and less than or equal to $7 \div 3$, the ratio between the first value and the second value (the first value (17.3%) $\div$ the second value (1.8%) = 9.61 or the first value (1.8%) $\div$ the second value (17.3%) = 0.10) is lower than $3 \div 7$ or exceeds $7 \div 3$, so that the diagnosis unit 120 may determine that the ratio does not fall within the critical ratio range. In addition, the diagnosis unit 120 may determine that the second distribution profile p2 does not satisfy the predetermined condition.

Hereinafter, an embodiment will be described in which the diagnosis unit 120 calculates a capacity loss rate based on the SOC of the first target point and the SOC of a second target point, and determines the capacity loss rate as a target value.

The diagnosis unit 120 may be configured to determine a target value based on the reference capacity set for each of the plurality of batteries, the first target point, and the second target point included in each of the plurality of first profiles. Here, the first profile may be a negative electrode profile, and the second target point may be a negative electrode activation final point (nf illustrated in FIG. 2) included in the negative electrode profile.

The diagnosis unit 120 may be configured to determine the target value based on the reference capacity set for each of the plurality of batteries, the first target point, and the second target point.

As described above, the reference capacity may be set as the positive electrode capacity Qp, the negative electrode capacity Qn, or the battery capacity Qb. As long as the reference capacity refers to a value indicating the state of the battery, the reference capacity is not limited to the positive electrode capacity Qp, the negative electrode capacity Qn, and the battery capacity Qb, and various values may be applied thereto.

For example, the diagnosis unit 120 may calculate the SOC of the second target point based on the ratio of a capacity value of the second target point to the reference capacity, and determine the SOC of the second target point as the target value.

For example, the diagnosis unit 120 may divide the capacity value of the second target point by the reference capacity to calculate the SOC of the second target point, and determine the calculated SOC as the target value. Here, the capacity value of the second target point refers to a capacity value corresponding to the second target point on the first profile. For example, in the embodiment of FIG. 2, the capacity value of the second target point may be a difference between the starting capacity (0 [Ah] in FIG. 2) of the first profile NP and the capacity (50 [Ah] in FIG. 2) of the second target point (nf in FIG. 2).

As another example, the diagnosis unit 120 may be configured to calculate the SOC of the first target point based on the ratio of the capacity value of the first target point to the reference capacity, calculate the SOC of the second target point based on the ratio of the capacity value of the second target point to the reference capacity, calculate the capacity loss rate based on the first reference value and the second reference value preset for each of the plurality of batteries and the SOC of the first target point and the SOC of the second target point, and determine the calculated capacity loss rate as the target value.

According to an embodiment, the diagnosis unit 120 may calculate the capacity loss rate through the following calculation process. The diagnosis unit 120 may calculate a first difference, which is a difference between the first reference value and the second reference value. Then, the diagnosis unit 120 may calculate a third difference, which is the difference between the SOC of the first target point and the SOC of the second target point. Finally, the diagnosis unit 120 may calculate the capacity loss rate by calculating the ratio of the third difference to the first difference.

Here, the first reference value may be preset as the SOC of a reference activation final point. The SOC of the reference activation final point may be calculated by dividing the capacity value of the reference activation final point by the reference capacity for the battery in the BOL state. The second reference value may be preset as the SOC of the reference activation initial point. That is, the SOC of the reference activation initial point may be preset as a value obtained by dividing the capacity value of the reference activation initial point by the reference capacity for the battery in the BOL state.

For example, the reference activation final point may be the positive electrode activation final point of the positive electrode profile acquired for the battery in the BOL state, and the reference activation initial point may be the positive electrode activation initial point of the positive electrode profile acquired for the battery in the BOL state.

For example, the diagnosis unit 120 may calculate the capacity loss rate using the following equation 1.

[Equation 1]

$$L_Q = 1 - \frac{nf_{MOL} - ni_{MOL}}{pf_{BOL} - pi_{BOL}}$$

Here, $L_Q$ is the capacity loss rate, $nf_{MOL}$ represents the SOC of the second target point, and $ni_{MOL}$ represents the SOC of the first target point. $pi_{BOL}$ represents the SOC of the positive electrode activation initial point in the positive electrode profile acquired for the battery in the BOL state, and $pf_{BOL}$ represents the SOC of the positive electrode activation final point in the positive electrode profile acquired for the battery in the BOL state. In addition, the middle of life (MOL) refers to a state in which the battery has been used to some extent, and indicates a stage where the performance of the battery has been degraded compared to the beginning of life (BOL), but the battery still operates normally.

As another example, the reference activation final point may be the negative electrode activation final point of the negative electrode profile acquired for the battery in the BOL state, and the reference activation initial point may be the negative electrode activation initial point of the negative electrode profile acquired for the battery in the BOL state.

For example, the diagnosis unit 120 may calculate the capacity loss rate using the following equation 2.

[Equation 2]

$$L_Q = 1 - \frac{nf_{MOL} - ni_{MOL}}{nf_{BOL} - ni_{BOL}}$$

Here, $L_Q$ is the capacity loss rate, $nf_{MOL}$ represents the SOC of the second target point, and $ni^{MOL}$ represents the SOC of the first target point. $nf_{BOL}$ represents the SOC of the negative electrode activation final point of the negative electrode profile acquired for the battery in the BOL state, and $ni_{BOL}$ represents the SOC of the negative electrode activation initial point of the negative electrode profile acquired for the battery in the BOL state.

For example, the capacity loss rate $L_Q$ calculated using Equation 1 and the capacity loss rate $L_Q$ calculated using Equation 2 are identical to each other. This is because "$pf_{BOL}$ - $pi_{BOL}$" and "$nf_{BOL}$ - $ni_{BOL}$" are the same values. For example, in the embodiment of FIG. 3, since a difference between $pf_{BOL}$ and $pi_{BOL}$ corresponds to a difference between $nf_{BOL}$ and $nf_{BOL}$, the capacity loss rate $L_Q$ calculated using Equation 1 and the capacity loss rate $L_Q$ calculated using Equation 2 are identical to each other.

The battery managing apparatus 100 according to the present disclosure may diagnose whether the battery pack is in the degradation imbalance state in terms of the degree of capacity loss, by calculating the capacity loss rate, which indicates the degradation state of the battery, as the target value.

Hereinafter, an embodiment in which the profile acquisition unit 110 determines the negative electrode profile NP will be described.

FIG. 5 is a diagram schematically illustrating the reference positive electrode profile Rp and the reference negative electrode profile Rn according to an embodiment of the present disclosure. In the embodiment of FIG. 5, the horizontal axis (X-axis) represents a capacity (Ah) and the vertical axis (Y-axis) represents a voltage (V).

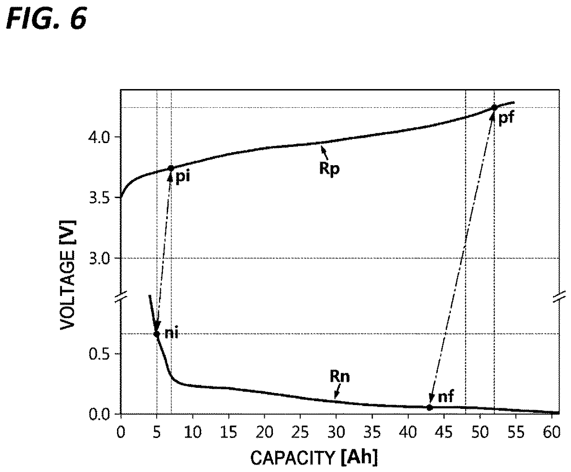

FIGS. 6 to 8 are reference diagrams for explaining an example of a procedure for generating a comparison profile S used for comparison with a battery profile BP according to an embodiment of the present disclosure.

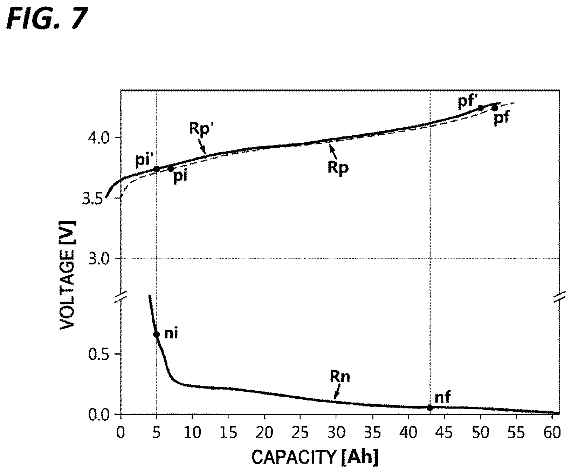

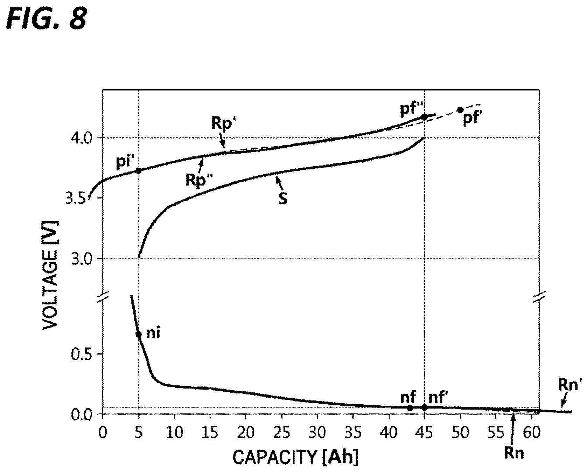

The procedure for generating the comparison profile S to be explained with reference to FIGS. 6 to 8 is performed in the order of a first routine (see FIG. 6) for setting the four points (a positive electrode activation initial point pi, a positive electrode activation final point pf, a negative electrode activation initial point ni, and a negative electrode activation final point nf) to correspond to a voltage range of interest, a second routine (see FIG. 7) for performing the profile shifting, and a third routine (see FIG. 8) for performing the capacity scaling. That is, the procedure for generating the comparison profile S according to an embodiment of the present disclosure includes the first to third routines.

Here, the positive electrode activation initial point pi refers to a positive electrode point at which a reaction starts during a charging process or a positive electrode point at which the reaction ends during a discharging process. The positive electrode activation final point pf refers to a positive electrode point at which the reaction ends during the charging process or a positive electrode point at which a reaction starts during the discharging process. In addition, the negative electrode activation initial point ni refers to a negative electrode point at which a reaction starts during the charging process or a negative electrode point at which the reaction ends during the discharging process. The negative electrode activation final point nf refers to a negative electrode point at which the reaction ends during the charging process or a negative electrode point at which a reaction starts during the discharging process.

First, referring to FIG. 6, the reference positive electrode profile Rp and the reference negative electrode profile Rn are identical to those illustrated in FIG. 5.

The profile acquisition unit 110 determines the positive electrode activation initial point pi, the positive electrode activation final point pf, the negative electrode activation initial point ni, and the negative electrode activation final point nf on the reference positive electrode profile Rp and the reference negative electrode profile Rn.

One of the positive electrode activation initial point pi and the negative electrode activation initial point ni depends on the other.

According to an embodiment, the difference between the voltage of the positive electrode activation initial point pi and the voltage of the negative electrode activation initial point ni may be set to be equal to the start voltage (minimum voltage) of the battery profile BP.

For example, the profile acquisition unit 110 may divide a positive electrode voltage range from a start point to an end point of the reference positive electrode profile Rp into a plurality of micro-voltage sections, and then, set a boundary point between two adjacent micro-voltage sections among the plurality of micro-voltage sections as the positive electrode activation initial point pi. Each micro-voltage section may have a predetermined size (e.g., 0.01 V). Then, the profile acquisition unit 110 may set a point that exists on the reference negative electrode profile Rn and has a voltage lower than the voltage of the positive electrode activation initial point pi by a first set voltage (e.g., 3 V) as the negative electrode activation initial point ni.

As another example, the profile acquisition unit 110 may divide a negative electrode voltage range from a start point to an end point of the reference negative electrode profile Rn into a plurality of micro-voltage sections of a predetermined size, and then, set a boundary point between two adjacent micro-voltage sections among the plurality of micro-voltage sections as the negative electrode activation initial point ni. Then, the profile acquisition unit 110 may set a point that exists on the reference positive electrode profile Rp and has a voltage greater than the voltage of the negative electrode activation initial point ni by the first set voltage, as the positive electrode activation initial point pi.

One of the positive electrode activation final point pf and the negative electrode activation final point nf depends on the other.

According to an embodiment, the difference between the voltage of the positive electrode activation final point pf and the voltage of the negative electrode activation final point nf may be set to be equal to an end voltage (maximum voltage) of the battery profile BP.

For example, the profile acquisition unit 110 may divide a positive electrode voltage range from a second set voltage to the end point of the reference positive electrode profile Rp into a plurality of micro-voltage sections of a predetermined size, and then set a boundary point between two adjacent micro-voltage sections among the plurality of micro-voltage sections as the positive electrode activation final point pf. Next, the profile acquisition unit 110 may set a point that exists on the reference negative electrode profile Rn and has a voltage lower than the voltage of the positive electrode activation final point pf by the second set voltage (e.g., 4 V), as the negative electrode activation final point nf.

As another example, the profile acquisition unit 110 may divide a negative electrode voltage range from the start point to the end point of the reference negative electrode profile Rn into a plurality of micro-voltage sections of a predetermined size, and then set a boundary point between two adjacent micro-voltage sections among the plurality of micro-voltage sections, as the negative electrode activation final point nf. Then, the profile acquisition unit 110 may set a point that exists on the reference positive electrode profile Rp and has a voltage greater than the voltage of the negative electrode activation final point nf by the second set voltage, as the positive electrode activation final point pf.

When a determination on the positive electrode activation initial point pi, the positive electrode activation final point pf, the negative electrode activation initial point ni, and the negative electrode activation final point nf is completed, the profile acquisition unit 110 shifts at least one of the reference positive electrode profile Rp and the reference negative electrode profile Rn to the left or to the right along the horizontal axis.

According to an embodiment, the difference between the capacity value of the positive electrode activation initial point pi and the capacity value of the positive electrode activation final point pf, the difference between the capacity value of the negative electrode activation initial point ni and the capacity value of the negative electrode activation final point nf, and the difference between the starting capacity of the battery profile BP and an end capacity of the battery profile BP, may be set to be identical to one another.

Referring to FIG. 7, for example, the profile acquisition unit 110 may shift the reference positive electrode profile Rp to the left (to a low-capacity side) or shift the reference negative electrode profile Rn to the right (to a high-capacity side) or perform both, such that the capacity values of the positive electrode activation initial point pi and the negative electrode activation initial point ni coincide with each other.

As another example, the profile acquisition unit 110 may shift the reference positive electrode profile Rp to the left or shift the reference negative electrode profile Rn to the right, or perform both, such that the capacity values of the positive electrode activation final point pf and the negative electrode activation final point nf coincide with each other.

FIG. 7 illustrates a situation in which the capacity value of the positive electrode activation initial point pi' coincides with the capacity value of the negative electrode activation initial point ni as a result of generating an adjusted positive electrode profile Rp' by shifting only the reference positive electrode profile Rp to the left. The adjusted positive electrode profile Rp' is the result of applying an adjustment procedure of performing shifting to the left by a difference in the capacity values of the positive electrode activation initial point pi and the negative electrode activation initial point ni, to the reference positive electrode profile Rp. Therefore, only the capacity values of the two points pi and pi' are different from each other, and the voltages of the two points pi and pi' are identical to each other. Only the capacity values of the two points pf and pf' are different from each other, and the voltages of the two points pf and pf' are identical to each other.

When the adjusted profiles Rp' and Rn in which at least one of the reference positive electrode profile Rp and the reference negative electrode profile Rn has been shifted are secured, the profile acquisition unit 110 scales the capacity range of at least one of the adjusted profiles Rp' and Rn.

According to an embodiment, a capacity scaling may be performed such that the capacity range between the positive electrode activation initial point and the positive electrode activation final point of the adjusted positive electrode profile Rp', the capacity range between the negative electrode activation initial point and the negative electrode activation final point of the adjusted negative electrode profile Rn, and the capacity range of the battery profile BP, are identical to one another.

According to an example illustrated in FIG. 8, the profile acquisition unit 110 performs an additional adjustment procedure (capacity scaling) for contracting or expanding at least one of the adjusted positive electrode profile Rp' and the reference negative electrode profile Rn along the horizontal axis. That is, the capacity range of the adjusted positive electrode profile Rp' may be contracted or expanded while the voltage range of the adjusted positive electrode profile Rp' is kept constant. Alternatively, the capacity range of the reference negative electrode profile Rn may be contracted or expanded while the voltage range of the reference negative electrode profile Rn is kept constant.

Referring to FIG. 8, the profile acquisition unit 110 may generate an adjusted positive electrode profile Rp" by contracting or expanding the adjusted positive electrode profile Rp' such that the capacity range between two points pi' and pf' of the adjusted positive electrode profile Rp' coincides with the capacity range of the battery profile BP. At this time, one of the two points pi' and pf' may be fixed. Accordingly, the capacity range between the two points pi' and pf" of the adjusted positive electrode profile Rp" may coincide with the capacity range of the battery profile BP.

In addition, the profile acquisition unit 110 may generate an adjusted negative electrode profile Rn' by contracting or expanding the reference negative electrode profile Rn such that the capacity range between the two points ni and nf of the reference negative electrode profile Rn also coincides with the capacity range of the battery profile BP. At this time, one of the two points ni and nf may be fixed. Accordingly, the capacity range between the two points ni and nf' of the adjusted negative electrode profile Rn' may coincide with the capacity range of the battery profile BP.

In FIG. 8, the adjusted positive electrode profile Rp" is the result of contracting the adjusted positive electrode profile Rp' illustrated in FIG. 7 along the capacity axis, and the adjusted negative electrode profile Rn' is the result of expanding the reference negative electrode profile Rn illustrated in FIG. 6 along the capacity axis.

The positive electrode activation final point pf" on the adjusted positive electrode profile Rp" corresponds to the positive electrode activation final point pf' on the adjusted positive electrode profile Rp'. The negative electrode activation final point nf on the adjusted negative electrode profile Rn' corresponds to the negative electrode activation final point nf on the reference negative electrode profile Rn.

The capacity range between the positive electrode activation initial point pi' and the positive electrode activation final point pf" of the adjusted positive electrode profile Rp" coincides with the capacity range of the battery profile BP. Similarly, the capacity range between the negative electrode activation initial point ni and the negative electrode activation final point nf' of the adjusted negative electrode profile Rn' coincides with the capacity range of the battery profile BP.

In addition, the capacity range between the two points pi' and pf" of the adjusted positive electrode profile Rp" coincides with the capacity range between the two points ni and nf' of the adjusted negative electrode profile Rn'. The profile acquisition unit 110 may generate a comparison profile S by subtracting a profile between the two points pi' and pf" of the adjusted positive electrode profile Rp" from a profile between the two points ni and nf' of the adjusted negative electrode profile Rn'.

The profile acquisition unit 110 may calculate an error (profile error) between the comparison profile S and the battery profile BP.

In this regard, various methods known at the time of filing the present disclosure may be used to determine the error between the two profiles, each of which may be represented in a two-dimensional coordinate system. For example, the root mean square error (RMSE) or integral value of an absolute value of the area between the two profiles may be used as the error between the two profiles.

The profile acquisition unit 110 may mutually map at least two of the adjusted positive electrode profile Rp", the adjusted negative electrode profile Rn', the positive electrode activation initial point pi', the positive electrode activation final point pf", the negative electrode activation initial point ni, the negative electrode activation final point nf, a first scale factor, a second scale factor, the comparison profile S, and the profile error, and record them in the storage unit 130. The first scale factor may indicate the ratio of the capacity difference between the two points pi' and pf" to the capacity difference between two points pi0 and pf0. The second scale factor may indicate the ratio of the capacity difference between the two points ni and nf' to the capacity difference between two points ni0 and nf0.

The profile acquisition unit 110 may calculate a positive electrode change ratio ps based on the reference positive electrode profile Rp and the adjusted positive electrode profile Rp". Here, the positive electrode change ratio ps indicates a change ratio of the adjusted positive electrode profile to the reference positive electrode profile. The profile acquisition unit 110 may calculate a negative electrode change ratio ns based on the reference negative electrode profile Rn and the adjusted positive electrode profile Rn'. Here, the negative electrode change ratio ns indicates a change ratio of the adjusted negative electrode profile to the reference negative electrode profile.

For example, the profile acquisition unit 110 may determine the first scale factor as the positive electrode change ratio ps and the second scale factor as the negative electrode change ratio ns.

As described above, when the positive electrode voltage range of the reference positive electrode profile Rp is divided into a plurality of micro-voltage sections, a boundary point between two adjacent micro-voltage sections among the plurality of micro-voltage sections may be set as the positive electrode activation initial point pi.

For example, when the positive electrode voltage range of the reference positive electrode profile Rp is divided into 100 micro-voltage ranges, the number of boundary points capable of being set as the positive electrode activation initial point pi may be 100. In addition, when the voltage range that is equal to or greater than the second set voltage in the reference positive electrode profile Rp is divided into 40 micro-voltage ranges, the number of boundary points capable of being set as the positive electrode activation final point pf may be 40. In this case, a maximum of 4,000 different comparison profiles may be generated.

It will be readily understood by those skilled in the art that as the size of the micro-voltage section decreases, the maximum number of comparison profiles that may be generated will increase, and conversely, as the size of the micro-voltage section increases, the maximum number of comparison profiles that may be generated will decrease.

The profile acquisition unit 110 may identify the minimum value among the profile errors of the plurality of comparison profiles generated as described above, and then acquire information mapped to the minimum profile error (*e.g.*, at least one of the positive electrode activation initial point, the positive electrode activation final point, the negative electrode activation initial point, the negative electrode activation final point, the first scale factor, and the second scale factor) from the storage unit 130.

When a comparison full-cell profile S illustrated in FIG. 8 has the minimum profile error with the battery profile BP, the adjusted reference negative electrode profile Rn' may be used as the negative electrode profile NP.

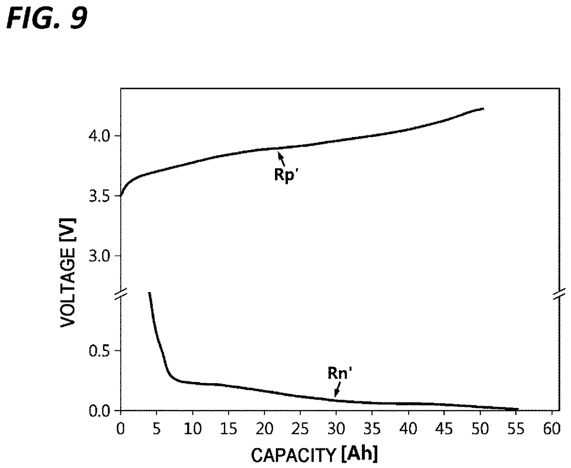

FIGS. 9 to 11 are reference diagrams for explaining another example of a procedure for generating a comparison profile U used for comparison with a battery profile BP according to an embodiment of the present disclosure. For reference, the embodiment according to FIGS. 9 to 11 is independent from the embodiment according to FIGS. 6 to 8. Therefore, terms or symbols commonly described in explaining the embodiment according to FIGS. 6 to 8 and the embodiment according to FIGS. 9 to 11 should be understood as being limited to the respective embodiments.

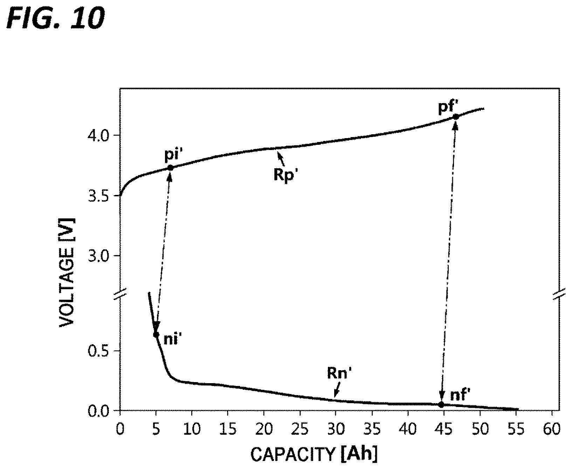

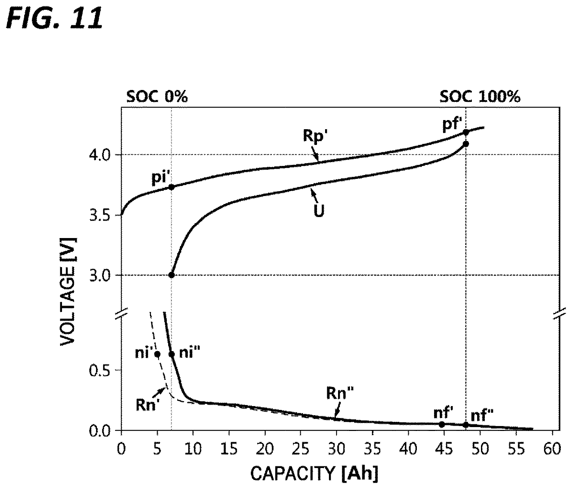

The procedure for generating the comparison profile U to be described with reference to FIGS. 9 to 11 is performed in the order of a fourth routine (see FIG. 9) for performing the capacity scaling, a fifth routine (see FIG. 10) for setting the four points (a positive electrode activation initial point, a positive electrode activation final point, a negative electrode activation initial point, and a negative electrode activation final point), and a sixth routine (see FIG. 11) for performing the profile shifting. That is, the procedure for generating the comparison profile U according to another embodiment of the present disclosure includes the fourth to sixth routines.

Referring to FIG. 9, the reference positive electrode profile Rp and the reference negative electrode profile Rn are identical to those illustrated in FIG. 5.

The profile acquisition unit 110 applies a first scale factor and a second scale factor selected from a scaling value range to the reference positive electrode profile Rp and the reference negative electrode profile Rn, respectively, to generate the adjusted positive electrode profile Rp' and the adjusted negative electrode profile Rn'.

The scaling value range may be predetermined, or may vary depending on the ratio of the size of the capacity range of the battery profile BP to the size of a capacity range of a reference profile R. For example, when the first scale factor and the second scale factor are selected from among values of the scaling value range (*e.g.,* 90 to 99%), which are spaced at intervals of 0.1% (*i.e.,* 90%, 90.1%, 90.2%, ..., 98.9%, 99%), 91 values may be selected as the first scale factors and the second scale factors, respectively. In this case, a maximum of 8,281 pairs of adjusted profiles may be generated according to the adjustment levels of 91 × 91 = 8,281 (combinations of the first scale factors and the second scale factors). The pair of the adjusted profiles mean the combination of the adjusted positive electrode profile and the adjusted negative electrode profile.

The adjusted positive electrode profile Rp' and the adjusted negative electrode profile Rn' illustrated in FIG. 9 illustrate the results of applying the first scale factor and the second scale factor, which are less than 100%, to the reference positive electrode profile Rp and the reference negative electrode profile Rn, respectively.

Since the first scale factor and the second scale factor are less than 100%, the adjusted positive electrode profile Rp' is obtained by contracting the reference positive electrode profile Rp along the horizontal axis, and the adjusted negative electrode profile Rn' is also obtained by contracting the reference negative electrode profile Rn along the horizontal axis. To help understanding, it is illustrated as an example where the start point of each of the reference positive electrode profile Rp and the reference negative electrode profile Rn is fixed, and only remaining portions thereof are reduced to the left along the horizontal axis.

Referring to FIG. 10, the profile acquisition unit 110 determines the positive electrode activation initial point pi', the positive electrode activation final point pf, the negative electrode activation initial point ni', and the negative electrode activation final point nf' on the adjusted positive electrode profile Rp' and the adjusted negative electrode profile Rn'.

One of the positive electrode activation initial point pi' and the negative electrode activation initial point ni' may depend on the other. In addition, one of the positive electrode activation final point pf' and the negative electrode activation final point nf' may depend on the other. In addition, one of the positive electrode activation initial point pi' and the positive electrode activation final point pf' may be set based on the other.

For example, when one of the positive electrode activation initial point pi', the positive electrode activation final point pf, the negative electrode activation initial point ni', and the negative electrode activation final point nf', is set, remaining three points may be automatically set by the first set voltage, the second set voltage, and/or the size of the capacity range of the battery profile BP (*e.g.*, the charging capacity of 0% to 100% SOC).

For example, the profile acquisition unit 110 may divide the positive electrode voltage range from a start point to an end point (or second set voltage) of the adjusted positive electrode profile Rp' into a plurality of micro-voltage sections, and then set a boundary point between two adjacent micro-voltage sections among the plurality of micro-voltage sections as the positive electrode activation initial point pi'. Then, the profile acquisition unit 110 may set a point that exists on the adjusted negative electrode profile Rn and has a voltage of the positive electrode activation initial point pi' by the first set voltage (*e.g.*, 3 V), as the negative electrode activation initial point ni'.

As another example, the profile acquisition unit 110 may divide a negative electrode voltage range from a start point to an end point of the adjusted negative electrode profile Rn' into a plurality of micro-voltage sections of a predetermined size, and then set a boundary point between two adjacent micro-voltage sections among the plurality of micro-voltage sections, as the negative electrode activation initial point ni'. Then, the profile acquisition unit 110 may set a point that exists on the adjusted positive electrode profile Rp' and has a voltage greater than the negative electrode activation initial point ni' by the first set voltage, as the positive electrode activation initial point pi'.

As still another example, the profile acquisition unit 110 may divide the voltage range from the second set voltage to the end point of the adjusted positive electrode profile Rp' into a plurality of micro-voltage sections of a predetermined size, and then, set a boundary point between two adjacent micro-voltage sections among the plurality of micro-voltage sections, as the positive electrode activation final point pf'. Then, the profile acquisition unit 110 may set a point that exists on the adjusted negative electrode profile Rn' and has a voltage lower than the voltage of the positive electrode activation final point pf' by the second set voltage (*e.g.*, 4 V), as the negative electrode activation final point nf'.

As still another example, the profile acquisition unit 110 may divide the negative electrode voltage range from the start point to the end point of the adjusted negative electrode profile Rn' into a plurality of micro-voltage sections of a predetermined size, and then, set a boundary point between two adjacent micro-voltage sections among the plurality of micro-voltage sections, as the negative electrode activation final point nf'. Then, the profile acquisition unit 110 may set a point that exists on the adjusted positive electrode profile Rp' and has a voltage greater than the voltage of the negative electrode activation final point nf' by the second set voltage, as the positive electrode activation final point pf.

When one of the positive electrode activation initial point pi', the positive electrode activation final point pf', the negative electrode activation initial point ni', and the negative electrode activation final point nf', is determined, the profile acquisition unit 110 may additionally determine remaining three points based on the determined point.

For example, when the positive electrode activation initial point pi' is determined first, the profile acquisition unit 110 may set a point on the adjusted positive electrode profile Rp', which has a capacity value greater than the capacity value of the positive electrode activation initial point pi' by the size of the capacity range of the battery profile BP, as the positive electrode activation final point pf'. In addition, the profile acquisition unit 110 may search for a point having a voltage lower than the voltage of the positive electrode activation initial point pi' by the first set voltage from the adjusted negative electrode profile Rn', and set the searched point as the negative electrode activation initial point ni'. In addition, the profile acquisition unit 110 may set a point on the adjusted negative electrode profile Rn', which has a capacity value greater than the capacity value of the negative electrode activation initial point ni' by the size of the capacity range of the battery profile BP, as the negative electrode activation final point nf'.

As another example, when the positive electrode activation final point pf' is first determined, the profile acquisition unit 110 may set a point on the adjusted positive electrode profile Rp', which has a capacity value less than the capacity value of the positive electrode activation final point pf' by the size of the capacity range of the battery profile BP, as the positive electrode activation initial point pi'. In addition, the profile acquisition unit 110 may search for a point having a voltage lower than the voltage of the positive electrode activation final point pf' by the second set voltage from the adjusted negative electrode profile Rn', and set the searched point as the negative electrode activation final point nf'. In addition, the profile acquisition unit 110 may set a point on the adjusted negative electrode profile Rn', which has a capacity value less than the capacity value of the negative electrode activation final point nf' by the size of the capacity range of the battery profile BP, as the negative electrode activation initial point ni'.

As still another example, when the negative electrode activation initial point ni' is determined, the profile acquisition unit 110 may set a point on the adjusted negative electrode profile Rn', which has a capacity value greater than the capacity value of the negative electrode activation initial point ni' by the size of the capacity range of the battery profile BP, as the negative electrode activation final point nf. In addition, the profile acquisition unit 110 may search for a point having a voltage higher than the voltage of the negative electrode activation initial point ni' by the first set voltage from the adjusted positive electrode profile Rp', and set the searched point as the positive electrode activation initial point pi'. In addition, the profile acquisition unit 110 may set a point on the adjusted positive electrode profile Rp', which has a capacity value greater than the capacity value of the positive electrode activation initial point pi' by the size of the capacity range of the battery profile BP as the positive electrode activation final point pf'.

As still another example, when the negative electrode activation final point nf' is determined, the profile acquisition unit 110 may set a point on the adjusted negative electrode profile Rn', which has a capacity value less than the capacity value of the negative electrode activation final point nf' by the size of the capacity range of the battery profile BP, as the negative electrode activation initial point ni'. In addition, the profile acquisition unit 110 may search for a point having a voltage higher than the voltage of the negative electrode activation final point nf' by the second set voltage from the adjusted positive electrode profile Rp', and set the searched point as the positive electrode activation final point pf'. In addition, the profile acquisition unit 110 may set a point on the adjusted positive electrode profile Rp', which has a capacity value less than the capacity value of the positive electrode activation final point pf' by the size of the capacity range of the battery profile BP, as the positive electrode activation initial point pi'.

When a determination on the positive electrode activation initial point pi', the positive electrode activation final point pf', the negative electrode activation initial point ni', and the negative electrode activation final point nf' is completed based on the pair of the first scale factor and the second scale factor, the profile acquisition unit 110 may shift at least one of the adjusted positive electrode profile Rp' and the adjusted negative electrode profile Rn' to the left or to the right along the horizontal axis, such that capacity values of the positive electrode activation initial point pi' and the negative electrode activation initial point ni' coincide with each other, or capacity values of the positive electrode activation final point pf and the negative electrode activation final point nf coincide with each other.

The adjusted negative electrode profile Rn" illustrated in FIG. 11 is formed by shifting only the adjusted negative electrode profile Rn' illustrated in FIG. 10 to the right. Accordingly, capacity values of the positive electrode activation initial point pi' and the negative electrode activation initial point ni" coincide with each other. In this regard, since the capacity difference between the positive electrode activation initial point pi' and the positive electrode activation final point pf' is identical to the capacity difference between the negative electrode activation initial point ni' and the negative electrode activation final point nf', when the capacity values of the positive electrode activation initial point pi' and the negative electrode activation initial point ni" coincide with each other, the capacity values of the positive electrode activation final point pf' and the negative electrode activation final point nf" also coincide with each other.

Referring to FIG. 11, the profile acquisition unit 110 may generate a comparison profile U by subtracting a partial profile between the two points pi' and pf' of the adjusted positive electrode profile Rp' from a partial profile between two points ni" and nf" of the adjusted negative electrode profile Rn".

The profile acquisition unit 110 may calculate an error (profile error) between the comparison profile U and the battery profile BP.

The profile acquisition unit 110 may mutually map at least two of the adjusted positive electrode profile Rp', the adjusted negative electrode profile Rn", the positive electrode activation initial point pi', the positive electrode activation final point pf, the negative electrode activation initial point ni", the negative electrode activation final point nf', the first scale factor, the second scale factor, the comparison profile U, and the profile error, and record them in the storage unit 130.

The profile acquisition unit 110 may calculate a positive electrode change ratio ps based on the reference positive electrode profile Rp and the adjusted positive electrode profile Rp'. Here, the positive electrode change ratio ps indicates a change ratio of the adjusted positive electrode profile to the reference positive electrode profile. The profile acquisition unit 110 may calculate a negative electrode change ratio ns based on the reference negative electrode profile Rn and the adjusted positive electrode profile Rn". Here, the negative electrode change ratio ns indicates a change ratio of the adjusted negative electrode profile to the reference negative electrode profile.

For example, the profile acquisition unit 110 may determine the first scale factor as the positive electrode change ratio ps, and the second scale factor as the negative electrode change ratio ns.

As described above, the profile acquisition unit 110 may generate a comparison profile corresponding to each pair of the first scale factor and the second scale factor selected from the scaling value range. Since there are a plurality of pairs of the first scale factors and the second scale factors, it is obvious that a plurality of comparison profiles will also be generated. The profile acquisition unit 110 may identify the minimum value among the profile errors of the plurality of comparison profiles, and then, acquire information mapped to the minimum profile error from the storage unit 130.

When a comparison full-cell profile U illustrated in FIG. 11 has a minimum profile error with the battery profile BP, the adjusted reference negative electrode profile Rn" may be used as the negative electrode profile NP.

The battery managing apparatus 100 according to the present disclosure may be applied to a battery management system (BMS). That is, the BMS according to the present disclosure may include the battery managing apparatus 100 described above. In this configuration, at least some of the respective components of the battery managing apparatus 100 may be implemented by supplementing or adding the functions of components included in a conventional BMS. For example, the profile acquisition unit 110, the diagnosis unit 120, and the storage unit 130 of the battery managing apparatus 100 may be implemented as components of the BMS.

In addition, the battery managing apparatus 100 according to the present disclosure may be provided in a battery pack. That is, the battery pack according to the present disclosure may include the battery managing apparatus 100 described above and one or more batteries. In addition, the battery pack may further include electrical components (relays and fuses) and a case.

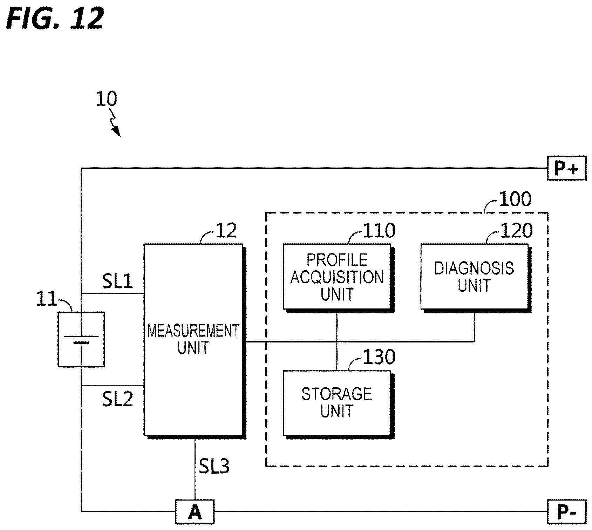

FIG. 12 is a diagram illustrating an example configuration of a battery pack 10 according to another embodiment of the present disclosure.

A positive terminal of a battery 11 may be connected to a positive terminal P+ of the battery pack 10, and a negative terminal of the battery 11 may be connected to a negative terminal P- of the battery pack 10.

A measurement unit 12 may be connected to a first sensing line SL1, a second sensing line SL2, and a third sensing line SL3. For example, the measurement unit 12 may be connected to the positive terminal of the battery 11 through the first sensing line SL1 and connected to the negative terminal of the battery 11 through the second sensing line SL2. The measurement unit 12 may measure the voltage of the battery 11 based on the voltage measured from each of the first sensing line SL1 and the second sensing line SL2.

The measurement unit 12 may be connected to a current measurement unit A through the third sensing line SL3. For example, the current measurement unit A may be an ammeter or a shunt resistor capable of measuring a charging current and a discharging current of the battery 11. The measurement unit 12 may measure a charging current of the battery 11 through the third sensing line SL3 to calculate a charging amount. In addition, the measurement unit 12 may measure a discharging current of the battery 11 through the third sensing line SL3 to calculate a discharging amount.

An external device (not illustrated) may have one end connected to the positive terminal P+ of the battery pack 10 and the other end connected to the negative terminal P- of the battery pack 10. Accordingly, the positive terminal of the battery 11, the positive terminal P+ of the battery pack 10, the external device, the negative terminal P- of the battery pack 10, and the negative terminal of the battery 11 may be electrically connected to one another.

For example, the external device may be a charger or a load such as a motor of an electric vehicle that receives power from the battery 11.

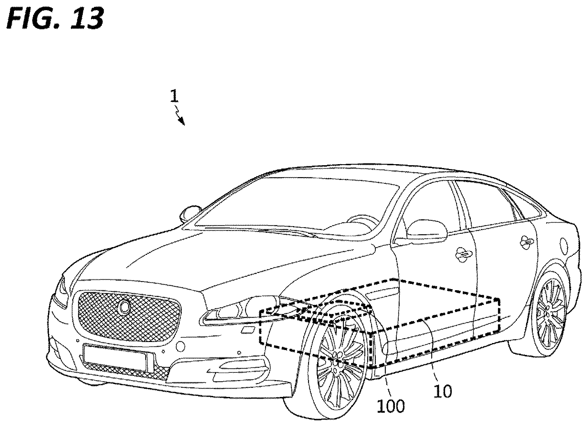

FIG. 13 is a view schematically illustrating a vehicle 1 according to still another embodiment of the present disclosure.

Referring to FIG. 13, the battery pack 10 according to the embodiment of the present disclosure may be included in the vehicle 1 such as an electric vehicle (EV) or a hybrid vehicle (HV). Here, the battery pack 10 may be the battery pack 10 described above. The battery pack 10 may drive the vehicle 1 by supplying power to a motor of the vehicle through an inverter equipped in the vehicle 1. Here, the battery pack 10 may include the battery managing apparatus 100 according to the embodiment of the present disclosure. That is, the vehicle 1 may include the battery managing apparatus 100. In this case, the battery managing apparatus 100 may be an on-board device included in the vehicle 1.

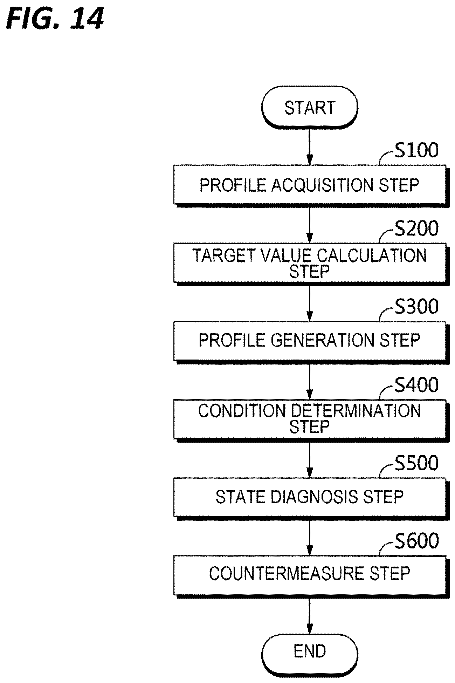

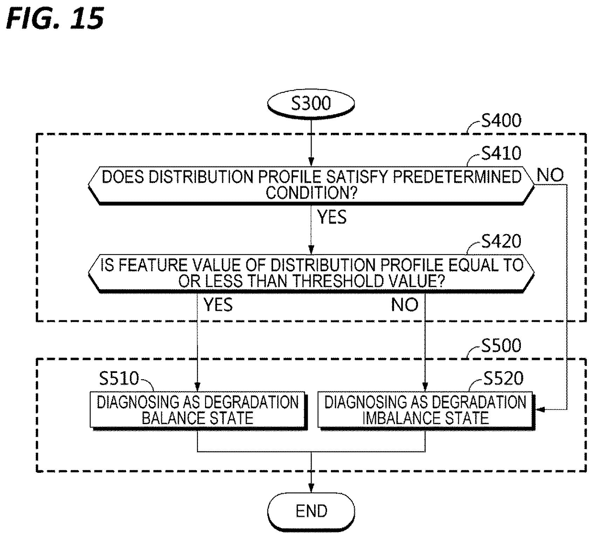

FIG. 14 is a diagram schematically illustrating a battery managing method according to still another embodiment of the present disclosure. FIG. 15 is a diagram schematically illustrating a condition determination step and a state diagnosis step of the battery managing method according to still another embodiment of the present disclosure.

Referring to FIG. 14, the battery managing method may include a profile acquisition step S100, a target value calculation step S200, a profile generation step S300, a condition determination step S400, and a state diagnosis step S500.

Each step of the battery managing method may be performed by the battery managing apparatus 100. Hereinafter, for the convenience of explanation, the contents that overlap with the aforementioned contents will be omitted or briefly described.

The profile acquisition step S100 is a step of acquiring a first profile for each of a plurality of batteries included in the battery pack, and may be performed by the profile acquisition unit 110.

Here, the first profile may be a negative electrode profile, and a first target point included in the first profile may be a negative electrode activation initial point included in the negative electrode profile.

The target value calculation step S200 is a step of calculating target values for each of the plurality of batteries based on the first target points included in each of a plurality of the first profiles, and may be performed by the diagnosis unit 120.

For example, the diagnosis unit 120 may be configured to determine the target value based on the ratio of a capacity value of the first target point to a reference capacity set for each of the plurality of batteries.

For example, the diagnosis unit 120 may divide the capacity value of the negative electrode activation initial point $ni$ by the reference capacity to calculate the state of charge (SOC) of the negative electrode activation initial point $ni$, and determine the calculated SOC as the target value.

The profile generation step S300 is a step of generating a distribution profile indicating a correspondence relationship between a plurality of calculated target values and the number of each of the plurality of target values, and may be performed by the diagnosis unit 120.

The condition determination step S400 is a step of determining whether the distribution profile satisfies a predetermined condition, and may be performed by the diagnosis unit 120.

The state diagnosis step S500 is a step of diagnosing the state of the battery pack according to a determination result and may be performed by the diagnosis unit 120.

The countermeasure step S600 is a step of taking various countermeasures when it is determined that the battery is in a degradation imbalance state, as a diagnosis result of the battery, and may be performed by the diagnosis unit 120 or a separate control unit (not illustrated). For example, a low-rate charging may be performed during battery charging or a pack balancing function may be operated, or a user may visit an inspection service through receiving an appropriate alarm and attempt pack balancing or replace the battery pack when necessary. According to an embodiment, the receiver of such alarm output may be an external device that manages the battery pack, such as a BMS, a server, or a user terminal, or may include an external device, a display, or an audio device that diagnoses the state of the battery pack.

Referring to FIG. 15, in step S410, the diagnosis unit 120 may determine whether the distribution profile satisfies a predetermined condition. For example, the predetermined condition may be a condition for determining whether the distribution profile follows a Gaussian distribution. That is, the predetermined condition may be a condition for determining whether the distribution profile exhibits a shape similar to that of Gaussian distribution. When the value of step S410 is YES, step S420 may be performed. When the value of step S410 is NO, step S520 may be performed.

In step S420, the diagnosis unit 120 may determine whether a feature value of the distribution profile is less than or equal to a threshold value. The threshold value may be preset based on a beginning of life (BOL) state of the battery pack, a current state of the battery pack (*e.g.*, the degradation degree), a reference value derived from a reference pack corresponding to the battery pack, or a theoretically derived distribution profile. When the value of step S420 is YES, step S510 may be performed. When the value of step S420 is NO, step S520 may be performed.

Referring to FIG. 15, in step S510, the diagnosis unit 120 may diagnose the state of the battery pack as a degradation balance state. In step S520, the diagnosis unit 120 may diagnose the state of the battery pack as a degradation imbalance state.

Here, the degradation balance state indicates a state in which the degradation states of each of the plurality of batteries included in the battery pack may be considered uniform. The degradation imbalance state indicates a state in which the degradation state of each of the plurality of batteries included in the battery pack may be considered not uniform.

The embodiments of the present disclosure described above are implemented not only through the apparatus and method, but also through a program that implements functions corresponding to the configurations of the embodiments of the present disclosure, or a recording medium in which the program is recorded. The implementation may be readily implemented by an expert in the technical field to which the present disclosure belongs, from the description of the embodiments of the present disclosure described above.

Although the present disclosure has been described above through limited embodiments and drawings, the present disclosure is not limited thereto, and it is obvious that various modifications and variations are possible within the scope of the technical idea of the present disclosure and the equivalent scope of the patent claims to be described below by an ordinary skill in the art to which the present disclosure belongs.

In addition, the present disclosure described above allows for various substitutions, modifications, and changes thereof within the scope of the technical idea of the present disclosure by an ordinary skill in the art to which the present disclosure belongs. Thus, the present disclosure is not limited by the aforementioned embodiments and attached drawings, but the entirety or part of each of the embodiments may be selectively combined and configured so that various modifications thereof may be made.

**Claims**

**1.** A battery managing apparatus comprising:

a profile acquisition unit configured to acquire a first profile for each of a plurality of batteries included in a battery pack; and

a diagnosis unit configured to calculate a target value based on a capacity value for each of the plurality of batteries as a diagnostic factor on a basis of a first target point included in each of a plurality of first profiles, generate a distribution profile indicating a correspondence relationship between a plurality of calculated target values and the number of each of the plurality of target values, determine whether the distribution profile satisfies a predetermined condition, and diagnose a state of the battery pack according to a determination result.

2. The battery managing apparatus according to claim 1, wherein the first profile is a negative electrode profile, and the first target point is a negative electrode activation initial point indicating a negative electrode point at which a charging reaction starts or a discharging reaction ends in the negative electrode profile.

3. The battery managing apparatus according to claim 1, wherein the diagnosis unit is configured to diagnose the state of the battery pack as a degradation imbalance state, when the distribution profile does not satisfy the predetermined condition.

4. The battery managing apparatus according to claim 1, wherein the diagnosis unit is configured to compare a feature value of the distribution profile with a preset threshold value, and diagnose the state of the battery pack based on a comparison result, when the distribution profile satisfies the predetermined condition.

5. The battery managing apparatus according to claim 4, wherein the diagnosis unit is configured to:

   diagnose the state of the battery pack as a degradation imbalance state, when the feature value exceeds the threshold value, and
   diagnose the state of the battery pack as a degradation balance state, when the feature value is less than or equal to the threshold value.

6. The battery managing apparatus according to claim 4, wherein the diagnosis unit is configured to set the threshold value based on a degradation degree of the battery pack and a preset reference feature value.

7. The battery managing apparatus according to claim 1, wherein the diagnosis unit is configured to calculate a first value and a second value based on the plurality of target values, and determine whether the distribution profile satisfies the predetermined condition based on a ratio between the first value and the second value.

8. The battery managing apparatus according to claim 7, wherein the diagnosis unit is configured to determine a minimum value, a maximum value, and a reference value among the plurality of target values, calculate a difference between the minimum value and the reference value as the first value, and calculate a difference between the reference value and the maximum value as the second value.

9. The battery managing apparatus according to claim 8, wherein the diagnosis unit is configured to determine a target value having a maximum correspondence number among the plurality of target values as the reference value.

10. The battery managing apparatus according to claim 7, wherein the diagnosis unit is configured to:

    determine that the distribution profile satisfies the predetermined condition, when the ratio falls within a preset critical ratio range, and
    determine that the distribution profile satisfies the predetermined condition, when the ratio does not fall within the critical ratio range.

11. The battery managing apparatus according to claim 1, wherein the diagnosis unit is configured to calculate a state of charge (SOC) of the first target point based on a ratio of a capacity value of the first target point to a reference capacity set for each of the plurality of batteries, and determine the calculated SOC as the target value.

12. The battery managing apparatus according to claim 1, wherein the diagnosis unit is configured to determine the target value based on the reference capacity set for each of the plurality of batteries, the first target point, and a second target point included in each of the plurality of first profiles.

13. The battery managing apparatus according to claim 12, wherein the first profile is a negative electrode profile, and the second target point is a negative electrode activation final point included in the negative electrode profile.

14. The battery managing apparatus according to claim 1, wherein the diagnosis unit operates a function for resolving a degradation imbalance or outputs an alarm, when the state of the battery pack is diagnosed as a degradation imbalance state.

15. The battery managing apparatus according to claim 14, wherein the function for resolving the degradation imbalance is a pack balancing function.

**16.** A battery pack including the battery managing apparatus according to any one of claims 1 to 15.

**17.** A vehicle including the battery managing apparatus according to any one of claims 1 to 15.

**18.** A battery managing method comprising:

a profile acquisition step of acquiring a first profile for each of a plurality of batteries included in a battery pack;
a target value calculation step of calculating a target value based on a capacity value for each of the plurality of batteries as a diagnostic factor on the basis of a first target point included in each of a plurality of first profiles;
a profile generation step of generating a distribution profile indicating a correspondence relationship between a plurality of calculated target values and the number of each of the plurality of target values;
a condition determination step of determining whether the distribution profile satisfies a predetermined condition; and
a state diagnosis step of diagnosing a state of the battery pack according to a determination result.

**19.** The battery managing method according to claim 18, further comprising:
a countermeasure step of operating a function for resolving a degradation imbalance or outputting an alarm, when the state of the battery pack is diagnosed as a degradation imbalance state in the state diagnosis step.

**20.** A non-transitory readable storage medium having stored therein a program for executing a battery managing method, the battery managing method including:

a profile acquisition step of acquiring a first profile for each of a plurality of batteries included in a battery pack;
a target value calculation step of calculating a target value based on a capacity value for each of the plurality of batteries as a diagnosis factor on the basis of a first target point included in each of the plurality of first profiles;
a profile generation step of generating a distribution profile indicating a correspondence relationship between a plurality of calculated target values and the number of each of the plurality of target values;
a condition determination step of determining whether the distribution profile satisfies a predetermined condition; and
a state diagnosis step of diagnosing a state of the battery pack according to a determination result.

## FIG. 1

```
                                    ┌─ 100
        ┌──────────────────────────┐
        │   BATTERY MANAGING        │
        │      APPARATUS            │
        │  ┌─────────────────────┐  │
        │  │ PROFILE ACQUISITION │──┼── 110
        │  │       UNIT          │  │
        │  └─────────────────────┘  │
        │  ┌─────────────────────┐  │
        │  │   DIAGNOSIS UNIT    │──┼── 120
        │  └─────────────────────┘  │
        │  ┌─────────────────────┐  │
        │  │   STORAGE UNIT      │──┼── 130
        │  └─────────────────────┘  │
        └──────────────────────────┘
```

FIG. 2

## FIG. 3

## FIG. 4

*FIG. 5*

FIG. 6

## FIG. 7

FIG. 8

**FIG. 9**

FIG. 10

# FIG. 11

FIG. 12

**FIG. 13**

## FIG. 14

```
          ┌─────────┐
          │  START  │
          └────┬────┘
               │           ╭S100
      ┌────────▼─────────────┐
      │ PROFILE ACQUISITION  │
      │        STEP          │
      └────────┬─────────────┘
               │           ╭S200
      ┌────────▼─────────────┐
      │ TARGET VALUE         │
      │ CALCULATION STEP     │
      └────────┬─────────────┘
               │           ╭S300
      ┌────────▼─────────────┐
      │ PROFILE GENERATION   │
      │        STEP          │
      └────────┬─────────────┘
               │           ╭S400
      ┌────────▼─────────────┐
      │ CONDITION            │
      │ DETERMINATION STEP   │
      └────────┬─────────────┘
               │           ╭S500
      ┌────────▼─────────────┐
      │ STATE DIAGNOSIS STEP │
      └────────┬─────────────┘
               │           ╭S600
      ┌────────▼─────────────┐
      │ COUNTERMEASURE STEP  │
      └────────┬─────────────┘
               │
          ┌────▼────┐
          │   END   │
          └─────────┘
```

*FIG. 15*

```
                    ( S300 )
                       │
                       │                              ┌─S400
  ┌────────────────────┼─────────────────────────────────┐
  │                    │                          ┌─S410  │
  │          ╱DOES DISTRIBUTION PROFILE SATISFY PREDETERMINED╲ NO
  │          ╲         CONDITION?                          ╱──┤
  │                    │                                      │
  │                   YES                                     │
  │                    │                          ┌─S420      │
  │        ╱IS FEATURE VALUE OF DISTRIBUTION PROFILE EQUAL TO╲ │
  │        ╲     OR LESS THAN THRESHOLD VALUE?              ╱  │
  │              │                            │               │
  │             YES                          NO               │
  └──────────────┼────────────────────────────┼──────────────┘
                 │                             │            ┌─S500
  ┌──────────────┼────────────────────────────┼─────────────────┐
  │  S510─┐      │              ┌─S520         │                 │
  │  ┌────────────────────┐   ┌────────────────────┐             │
  │  │DIAGNOSING AS DEGRADATION│ │DIAGNOSING AS DEGRADATION│◄─────┤
  │  │   BALANCE STATE     │   │   IMBALANCE STATE  │             │
  │  └────────────────────┘   └────────────────────┘             │
  │           │                        │                         │
  │           └────────────────────────┤                         │
  └────────────────────────────────────┼─────────────────────────┘
                                        │
                                    ( END )
```

## INTERNATIONAL SEARCH REPORT

| International application No. |
| --- |
| **PCT/KR2025/000677** |

| **A.** | **CLASSIFICATION OF SUBJECT MATTER** |
| --- | --- |

**G01R 31/392**(2019.01)i; **G01R 31/396**(2019.01)i; **G01R 31/382**(2019.01)i

According to International Patent Classification (IPC) or to both national classification and IPC

| **B.** | **FIELDS SEARCHED** |
| --- | --- |

Minimum documentation searched (classification system followed by classification symbols)

G01R 31/392(2019.01); G01R 19/00(2006.01); G01R 31/36(2006.01); G01R 31/367(2019.01); G06N 3/08(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 팩(battery Pack), 프로파일(profile), 음극(cathode), 용량(capacity), 인자(factor), 분포(distribution), 상태(state), 진단(diagnosis)

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| X<br><br>Y<br><br>A | KR 10-2023-0136998 A (KOREA INSTITUTE OF ENERGY RESEARCH et al.) 04 October 2023 (2023-10-04)<br>    See paragraphs [0031]-[0072] and figures 1-10. | 1,3,16-18,20<br><br>14,15,19<br><br>2,4-13 |
| Y | KR 10-2024-0003170 A (SK ON CO., LTD.) 08 January 2024 (2024-01-08)<br>    See paragraph [0044] and figure 2. | 14,15,19 |
| A | KR 10-2023-0167249 A (SK INNOVATION CO., LTD. et al.) 08 December 2023 (2023-12-08)<br>    See paragraphs [0041]-[0116] and figures 2-12. | 1-20 |
| A | KR 10-2021-0154027 A (LG ENERGY SOLUTION, LTD.) 20 December 2021 (2021-12-20)<br>    See paragraphs [0002]-[0082], claims 1 and 5 and figure 3. | 1-20 |

☑ Further documents are listed in the continuation of Box C.     ☑ See patent family annex.

| | |
| --- | --- |
| *    Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **14 April 2025** | **14 April 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2025/000677** |

**C. DOCUMENTS CONSIDERED TO BE RELEVANT**

| Category* | Citation of document, with indication, where appropriate, of the relevant passages | Relevant to claim No. |
| --- | --- | --- |
| A | JP 2010-008067 A (SONY CORP.) 14 January 2010 (2010-01-14)<br>    See paragraphs [0027]-[0052]. | 1-20 |
| L | PCT/KR2025/000652 (LG ENERGY SOLUTION, LTD.) international application date 10 January 2025.<br>    See claims 1, 3-11, 13 and 15-20. | 1,3-12,14-18,20 |
| L | PCT/KR2025/000675 (LG ENERGY SOLUTION, LTD.) international application date 10 January 2025.<br>    See claims 1, 3-12 and 14-20. | 1,3-12,14-20 |
| L | PCT/KR2025/000679 (LG ENERGY SOLUTION, LTD.) international application date 10 January 2025.<br>    See claims 1, 3-11, 13 and 15-20. | 1,3-12,14-18,20 |

Form PCT/ISA/210 (second sheet) (July 2022)

**INTERNATIONAL SEARCH REPORT**
Information on patent family members

International application No.

**PCT/KR2025/000677**

| Patent document cited in search report | | | Publication date (day/month/year) | Patent family member(s) | | | Publication date (day/month/year) |
|---|---|---|---|---|---|---|---|
| KR | 10-2023-0136998 | A | 04 October 2023 | None | | | |
| KR | 10-2024-0003170 | A | 08 January 2024 | WO | 2024-005338 | A1 | 04 January 2024 |
| KR | 10-2023-0167249 | A | 08 December 2023 | CN | 117148154 | A | 01 December 2023 |
| | | | | US | 2023-0384392 | A1 | 30 November 2023 |
| KR | 10-2021-0154027 | A | 20 December 2021 | None | | | |
| JP | 2010-008067 | A | 14 January 2010 | CN | 101615706 | A | 30 December 2009 |
| | | | | CN | 101615706 | B | 26 September 2012 |
| | | | | JP | 4591560 | B2 | 01 December 2010 |
| | | | | KR | 10-2010-0002151 | A | 06 January 2010 |
| | | | | US | 2009-0315520 | A1 | 24 December 2009 |
| | | | | US | 2012-0146586 | A1 | 14 June 2012 |
| | | | | US | 8203306 | B2 | 19 June 2012 |
| | | | | US | 8629656 | B2 | 14 January 2014 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240005640